# EUROPÄISCHE PATENTANMELDUNG

(11) **EP 4 443 176 A1**
(43) Veröffentlichungstag der Anmeldung: **09.10.2024**
(21) Anmeldenummer: 23166813.8
(22) Anmeldetag: 05.04.2023
(51) Int. Cl.: G01R 31/28, G01R 31/40, G01R 31/42, G01R 1/04

(54) **VORRICHTUNG UND VERFAHREN ZUM PRÜFEN UND/ODER EINSTELLEN EINER LEISTUNGSELEKTRONIKEINHEIT**

(71) Anmelder: Sonplas GmbH, 94315 Straubing (DE)
(72) Erfinder: GIETL, Patrick, 94491 Hengersberg (DE); BIRKENEDER, Paul, 94501 Aldersbach (DE); DENK, Alexander, 84152 Mengkofen (DE); ERNST, Andreas, 94348 Atting (DE); SAMMET, Christian, 93109 Wiesent (DE)
(74) Vertreter: Wunderlich & Heim Patentanwälte PartG mbB

(57) **Zusammenfassung**

Die Erfindung betrifft eine Vorrichtung (10) und ein Verfahren zum Prüfen und/oder Einstellen einer Leistungselektronikeinheit (5), insbesondere für Kraftfahrzeuge, mit einer Aufnahme (30) zum Aufnehmen und Halten der zu prüfenden Leistungselektronikeinheit (5), einer Prüf-/Einstelleinrichtung (50), welche mit mindestens einem elektronischen Programm zum Durchführen von Prüf-/Einstellschritten an der Leistungselektronikeinheit (5) ausgebildet ist, und einer Vielzahl von Anschlusselementen (40), welche zum Verbinden der Prüf-/Einstelleinrichtung (50) mit der in der Aufnahme angeordneten Leistungselektronikeinheit (5) ausgebildet sind, wobei in dem Verbindungszustand ein Prüfen und/oder Einstellen von Funktionen der Leistungselektronikeinheit (5) durch die Prüfeinrichtung (50) durchführbar ist. Nach der Erfindung ist vorgesehen, dass die Aufnahme als ein Wechselmodul (30) ausgebildet ist, welches leicht lösbar und wechselbar an einem Grundrahmen (12) der Vorrichtung (10) angeordnet ist, dass an der Prüf-/Einstelleinrichtung (50) ein einheitlicher erster Verbindungsabschnitt (56) zum Herstellen von elektrischen und/oder elektronischen Verbindungen ausgebildet ist, dass an dem Wechselmodul (30) ein zum ersten Verbindungsabschnitt (56) passender zweiter Verbindungsabschnitt (36) zum Herstellen der elektrischen und/oder elektronischen Verbindungen zwischen der Prüf-/Einstelleinrichtung (50) und dem Wechselmodul (30) ausgebildet ist, und dass die Vielzahl von Anschlusselementen (40) an dem Wechselmodul (30) angeordnet und passend zum Anschließen einer vorgegebenen Leistungselektronikeinheit (5) ausgebildet ist.

## Beschreibung

Die Erfindung betrifft eine Vorrichtung zum Prüfen und/oder Einstellen einer Leistungselektronikeinheit, insbesondere für Kraftfahrzeuge, mit einer Aufnahme zum Aufnehmen und Halten der zu bearbeitenden Leistungselektronikeinheit, einer Prüf-/Einstelleinrichtung, welche mit mindestens einem elektronischen Programm zum Durchführen von Prüf-/Einstellschritten an der Leistungselektronikeinheit ausgebildet ist, und einer Vielzahl von Anschlusselementen, welche zum Verbinden der Prüfeinrichtung mit der in der Aufnahme angeordneten Leistungselektronikeinheit ausgebildet sind, wobei in dem Verbindungszustand ein Prüfen und/oder Einstellen von Funktionen der Leistungselektronikeinheit durch die Prüfeinrichtung durchführbar ist, gemäß dem Oberbegriff des Anspruchs 1.

Die Erfindung betrifft weiterhin ein Verfahren zum Prüfen und/oder Einstellen einer Leistungselektronikeinheit, insbesondere für Kraftfahrzeuge, bei dem eine zu bearbeitende Leistungselektronikeinheit in einer Aufnahme einer Vorrichtung zum Prüfen und/oder Einstellen aufgenommen und gehalten wird, die zu bearbeitende Leistungselektronikeinheit über eine Vielzahl von Anschlusselementen mit einer Prüf-/Einstelleinrichtung verbunden wird und mittels der Prüf-/Einstelleinrichtung mit mindestens einem elektronischen Programm Prüf-/Einstellschritte an der Leistungselektronikeinheit zum Prüfen und/oder Einstellen von Funktionen der Leistungselektronikeinheit durchgeführt werden, gemäß dem Oberbegriff des Anspruchs 10.

Eine Leistungselektronikeinheit, häufig auch nur Leistungselektronik genannt, ist eine zentrale Komponente jedes elektrischen Antriebsstrangs, insbesondere in Hybrid- und Elektrofahrzeugen. Ihre Aufgabe im Fahrzeug ist insbesondere die Ansteuerung der elektrischen Maschine, die Kommunikation mit der Fahrzeugsteuerung, eine Umformung des elekrischen Stroms und/oder die Diagnose des Antriebs. Die Leistungselektronikeinheit leitet insbesondere die elektrische Energie von der Batterie in den mindestens einen Elektromotor weiter und wandelt dabei den als Gleichstrom gespeicherten Strom in Wechselstrom für die Motore um. Die Leistungselektronikeinheit kann mit elektronischen Steuerelementen versehen sein, welche programmgesteuert eine Frequenz des Wechselstroms, vorzugsweise variabel, einstellen, so dass der mindestens eine Elektromotor effizient und komfortabel betrieben werden kann. Die Leistungselektronikeinheit ist eine Komponente, welche für ein effizientes Antriebsverhalten bei elektrischen Antrieben, insbesondere bei Kraftfahrzeugen, wesentlich sein kann.

Eine Leistungselektronikeinheit ist vor dem Einbau, insbesondere in ein Kraftfahrzeug, auf eine einwandfreie Funktionsfähigkeit zu prüfen und/oder einzustellen, etwa zu kalibrieren oder mit Betriebsprogrammen zu versehen. Eine Leistungselektronikeinheit kann zahlreiche elektrische und elektronische Anschlüsse sowie Kühlfluidanschlüsse für eine häufig notwendige Kühlung von Bauteilen innerhalb der Leistungselektronikeinheit aufweisen.

Bisher ist üblich, die Leistungselektronikeinheit von einer Person manuell an einer Prüf-/Einstelleinrichtung anzuschließen, in welcher ein oder mehrere Prüf- und/oder Einstellprogramme zum Durchführen der Funktionsfähigkeit hinterlegt sind.

Das Anschließen und Prüfen/Einstellen umfasst grundsätzlich sensible Tätigkeiten, da schon beim Prüfen teilweise mit hohen Spannungen und Strömen gearbeitet werden muss, wie sie auch im Betrieb der Leistungselektronikeinheit zum Einsatz kommen. Wird die Leistungselektronikeinheit fehlerhaft angeschlossen oder wird ein falsches Programm an der Leistungselektronikeinheit benutzt, kann es zu Beschädigungen oder sogar zur Zerstörung der Leistungselektronikeinheit und/oder der Prüf-/Einstelleinrichtung kommen. Diese Gefahr besteht insbesondere dann, wenn eine relativ aufwändige Prüf-/Einstelleinrichtung für verschiedene Typen von Leistungselektronikeinheiten eingesetzt werden muss.

Der Erfindung liegt die **Aufgabe** zugrunde, eine Vorrichtung und ein Verfahren anzugeben, mit welchen eine Leistungselektronikeinheit besonders effizient und zuverlässig geprüft oder eingestellt werden kann.

Die Aufgabe wird durch eine Vorrichtung mit den Merkmalen des Anspruchs 1 und ein Verfahren mit den Merkmalen des Anspruchs 10 gelöst. Bevorzugte Ausführungsformen der Erfindung sind in den jeweils abhängigen Ansprüchen angegeben.

Die erfindungsgemäße Vorrichtung ist dadurch gekennzeichnet, dass die Aufnahme als ein Wechselmodul ausgebildet ist, welches leicht lösbar und wechselbar an einem Grundrahmen der Vorrichtung angeordnet ist, dass an der Prüf-/Einstelleinrichtung ein einheitlicher erster Verbindungsabschnitt zum Herstellen von elektrischen und/oder elektronischen Verbindungen ausgebildet ist, dass an dem Wechselmodul ein zum ersten Verbindungsabschnitt passender zweiter Verbindungsabschnitt zum Herstellen der elektrischen und/oder elektronischen Verbindungen zwischen der Prüf-/Einstelleinrichtung und dem Wechselmodul ausgebildet ist, und dass die Vielzahl von Anschlusselementen an dem Wechselmodul angeordnet und passend zum Anschließen einer vorgegebenen Leistungselektronikeinheit ausgebildet ist.

Im Sinne der vorliegenden Erfindung ist unter einer Leistungselektronikeinheit eine Einheit oder Komponente zu verstehen, welche eine oder mehrere der folgenden Funktionen umfasst: Inverter für den elektrischen Strom, Ladeelektronik, Batteriemanagement, sonstige Steuergerät-Funktionen.

Eine Grundidee der Erfindung liegt darin, an der Vorrichtung zum Prüfen und/oder Einstellen einer Leistungselektronik die Aufnahme für die Leistungselektronikeinheit als ein Wechselmodul auszubilden. Dabei ist grundsätzlich für jeden Typ einer Leistungselektronikeinheit ein eigenständiges Wechselmodul vorgesehen, an welchem die jeweiligen Anschlusselemente speziell für den vorgesehenen Typ der Leistungselektronikeinheit angeordnet und ausgebildet sind. Schon dies erleichtert ein Anschließen der Leistungselektronikeinheit und kann Fehlanschlüsse von unterschiedlichen Typen verhindern. Durch die Abstimmung des Wechselmoduls auf eine spezielle Leistungselektronikeinheit können insbesondere die Verbindungselemente und Verbindungsleitungen relativ kurz gehalten werden. Kurze Leitungen sind insbesondere bei hochfrequenten elektronischen Messungen förderlich für eine hohe Prüfgenauigkeit.

Gemäß einem weiteren Aspekt der Erfindung kann ein stationärer Teil der Vorrichtung so ausgebildet sein, dass das Wechselmodul daran leicht lösbar angebracht und wechselbar ist. Insbesondere kann an der Prüf-/Einstelleinrichtung ein einheitlicher erster Verbindungsabschnitt zum Herstellen von elektrischen und/oder elektronischen Verbindungen ausgebildet sein. Passend hierzu ist an dem Wechselmodul ein zweiter Verbindungsabschnitt passend ausgebildet, so dass das Wechselmodul im Wesentlichen durch Herstellen von Steckverbindungen, vorzugsweise bereits mit einer Einschubbewegung, mit der restlichen Vorrichtung verbunden werden kann. Die Verbindungsabschnitte können auch mechanische Verbindungselemente zur mechanischen Positionierung und zum festen Anbringen des Wechselmoduls umfassen. Neben dem einheitlichen Verbindungsabschnitt können auch weitere Verbindungen zwischen dem Wechselmodul und dem Grundrahmen vorgesehen sein, insbesondere wenn dieser mit weiteren funktionalen mechanischen, elektrischen und/oder elektronischen Grundkomponenten versehen ist. Die einheitlichen Verbindungsabschnitte sind vorzugsweise zwischen dem Wechselmodul und Prüf-/Einstelleinrichtung angeordnet, um diese effizient und lösbar miteinander zu verbinden.

Nach der Erfindung kann so eine insgesamt aufwändige und kostenintensive Vorrichtung zum Prüfen und/oder Einstellen einer Leistungselektronikeinheit für eine Vielzahl unterschiedlicher Typen von Leistungselektronikeinheiten zum Einsatz kommen, wobei stets ein sicheres und zuverlässiges Prüfen und/oder Einstellen durch ein jeweils angepasstes Wechselmodul sichergestellt ist.

Das Prüfen kann eine Prüfung der Funktionsfähigkeit der elektrischen, elektronischen sowie weiterer Funktionalitäten umfassen, etwa einer Kühlung der Leistungselektronikeinheit. Ein Einstellen kann allein oder in Kombination mit einem Prüfen erfolgen. Insbesondere kann ein Prüfen kombiniert mit einem Kalibrieren von bestimmten Elementen und Parametern der Leistungselektronikeinheit sein. Alternativ oder ergänzend kann ein Einstellen der Leistungselektronikeinheit erfolgen, etwa durch Aufspielen entsprechender Betriebsprogramme für einzelne Komponenten der Leistungselektronikeinheit und/oder ein Kalibrieren einzelner Komponenten.

Eine besonders bevorzugte Ausführungsform der Erfindung besteht darin, dass das Wechselmodul verschiebbar gelagert ist. Das Wechselmodul, welches etwa kastenförmig ausgebildet sein kann, kann so insbesondere über eine Verschiebeführung in die Einsetzposition an der Vorrichtung eingeschoben werden. Das Verschieben kann vorzugsweise linear oder alternativ oder ergänzend mit einem Verschwenken erfolgen. Hierdurch wird insgesamt ein einfaches, schnelles und positionsgenaues Einsetzen des Wechselmoduls sowie ein effizientes Lösen und Wechseln ermöglicht.

Nach einer Weiterbildung der Erfindung ist es vorteilhaft, dass an dem Grundrahmen ein Einsetzbereich für das Wechselmodul ausgebildet ist und dass eine Führungseinrichtung und/oder Anschlag zum positionsgenauen Einschieben des Wechselmoduls in den Grundrahmen angeordnet sind. Die einzelnen Wechselmodule sind dabei hinsichtlich ihrer äußeren Gestaltung gleich oder ähnlich ausgebildet, so dass diese jeweils in den vorgesehenen Einsetzbereich am Grundrahmen eingesetzt werden können. Insbesondere ist ein geführtes Einsetzen, insbesondere ein Einschieben, mittels einer Führungseinrichtung vorgesehen. Das Einschieben kann manuell oder automatisch durch eine entsprechende Einsetzeinrichtung, insbesondere eine Einschiebeinrichtung, durchgeführt werden. Weiter kann ein Anschlag vorgesehen sein, welcher ein Einsetzen bis zu einer durch den Anschlag definierten Einsetzposition ermöglicht. Weiter kann eine Positionier und Verriegelungseinrichtung angeordnet sein, mit welcher das Wechselmodul am Grundrahmen in einer definierten Position angeordnet und fixiert werden kann. Dies erlaubt dann ein sicheres Anschließen der verschiedenen Verbindungselemente. Der Grundrahmen kann dabei nicht nur als ein Traggestell sondern als eine sogenannte Grundmaschine ausgebildet sein, welche neben einer Tragfunktion auch weitere mechanische, elektrische und/oder elektronische Grundkomponenten umfasst, wie die Stromversorgung, Anschluss- und Verbindungsstecker, Bedieneinheiten, Motore, Sensoren, Steuerungselemente etc.

Nach einer weiteren Ausführungsvariante der Erfindung ist es bevorzugt, dass der zweite Verbindungsabschnitt an einer Rückseite des Wechselmoduls angeordnet ist und dass ein Aufnahmebereich für die Leistungselektronikeinheit an dem Wechselmoduls ausgebildet ist. Dies ermöglicht ein leichtes und einfaches Wechseln der Wechselmodule, wobei weiter die zu prüfende Leistungselektronikeinheit von vorne und/oder oben in das Wechselmodul einsetzbar ist. Am Grundrahmen kann eine Öffnung an einer Vorderseite zum Zuführen der zu prüfenden Leistungselektronikeinheit in den Aufnahmebereich angeordnet sein.

Eine besonders effiziente Handhabung der zu prüfenden Leistungselektronikeinheit wird durch eine Weiterbildung der Erfindung erreicht, dass an dem Grundrahmen eine Fördereinrichtung zum Zu- und/oder Abführen der Leistungselektronikeinheit in eine beziehungsweise aus einer Prüf-/Einstellposition angeordnet ist.

Eine weitergehende Automatisierung des Bearbeitungsvorganges an der Leistungselektronikeinheit wird bei einer Ausführungsvariante der Erfindung dadurch erzielt, dass ein oder mehrere Anschlusselemente zwischen einer Rückzugsposition und einer Anschlussposition verstellbar gelagert und mittels mindestens einer Stelleinrichtung zum automatischen Anschließen und/oder Lösen der Anschlusselemente an bzw. von der Leistungselektronikeinheit verstellbar sind. Die Stelleinrichtung kann insbesondere Linearantriebe, besonders bevorzugt pneumatische Stellzylinder, umfassen. Die zu bearbeitende Leistungselektronikeinheit kann vorzugsweise mittels einem Werkstückträger zu und/oder in das Wechselmodul gefördert und dann automatisch mittels der mindestens einen Stelleinrichtung angeschlossen werden, um anschließend das Prüf-/oder Einstellverfahren durchzuführen.

Die Anschlusselemente können grundsätzlich in jeder geeigneten Weise ausgebildet sein. Besonders bevorzugt ist es nach einer Weiterbildung der Erfindung, dass die Anschlusselemente zum Bilden einer elektrischen, elektronischen und/oder fluidischen Steckverbindung ausgebildet sind. Die elektrischen Verbindungen dienen zur Übertragung von elektrischem Strom. Die elektronischen Steckverbindungen dienen insbesondere als eine Datenverbindung. Die fluidischen Steckverbindungen können insbesondere als Pneumatik oder hydraulische Steckverbindungen ausgebildet sein.

Ein besonders effizienter modularer Aufbau ergibt sich nach einer Ausführungsform der Erfindung dadurch, dass die Prüf-/Einstelleinrichtung als ein Modul ausgebildet ist, welches verstellbar, insbesondere verschiebbar, gegenüber dem Grundrahmen gelagert ist. Die Prüf-/Einstelleinrichtung kann vorzugsweise auf Rollen verschiebbar gelagert sein. Dies ermöglicht einen eventuell notwendigen Austausch der Prüf-/Einstelleinrichtung für das Bearbeiten von stark unterschiedlichen Leistungselektronikeinheiten. Auch zu Wartungs- oder Reparaturzwecken kann so ein einfacher Austausch auch der Prüf-/Einstelleinrichtung erfolgen. Zudem kann hierdurch bei Bedarf eines anschließendes Wechselmoduls erleichtert werden.

Nach einer weiteren Ausführungsvariante der Erfindung ist es vorteilhaft, dass das Wechselmodul und/oder die Prüf-/Einstelleinrichtung auf Rollen verschiebbar gelagert und insbesondere als ein Trolley ausgebildet sind. Insbesondere kann ein Trolley mit Rollen zum Verschieben auf einem Boden oder einer Grundfläche ausgebildet sein. Dies ermöglicht ein einfaches Wechseln auch eines relativ schweren Wechselmoduls oder der Prüf-/Einstelleinrichtung durch eine Bedienperson. Weiter kann vorgesehen sein, dass das Wechselmodul zwischen dem Grundrahmen und der Prüf-/Einstelleinrichtung angeordnet wird. Zum einfachen Wechseln des Wechselmodul kann die Prüf-/Einstelleinrichtung leicht entfernt werden, um einen Zugang zum Wechselmodul freizugeben.

Das erfindungsgemäße Verfahren ist dadurch gekennzeichnet, dass die Aufnahme als ein Wechselmodul ausgebildet ist, welches leicht lösbar und wechselbar an einem Grundrahmen der Vorrichtung angeordnet wird, dass an der Prüf-/Einstelleinrichtung ein einheitlicher erster Verbindungsabschnitt zum Herstellen von elektrischen und/oder elektronischen Verbindungen und an dem Wechselmodul ein zum ersten Verbindungsabschnitt passender zweiter Verbindungsabschnitt zum Herstellen der elektrischen und/oder elektronischen Verbindungen zwischen der Prüf-/Einstelleinrichtung und dem Wechselmodul ausgebildet sind, wobei die beiden Verbindungsabschnitte miteinander verbunden werden, und dass die Vielzahl von Anschlusselementen an dem Wechselmodul angeordnet, wobei die Anschlusselemente an dem Wechselmodul an der zu prüfenden Leistungselektronikeinheit angeschlossen werden.

Das erfindungsgemäße Verfahren kann insbesondere mit der zuvor beschriebenen erfindungsgemäßen Vorrichtung durchgeführt werden. Hierbei können sich die zuvor beschriebenen Vorteile ergeben.

Eine bevorzugte Verfahrensvariante besteht nach der Erfindung darin, dass das Zuführen der Leistungselektronikeinheit, das Anschließen der Anschlusselemente, das Prüfen und/oder das Abführen der Leistungselektronikeinheit teilweise oder vollständig automatisch gesteuert durchgeführt werden. Dies ermöglicht eine teilweise oder vollständige Automatisierung eines Prüf- und Einstellvorganges. Diese Vorgänge können somit besonders effizient und zuverlässig durchgeführt werden.

Die Erfindung wird nachfolgend anhand von bevorzugten Ausführungsbeispielen weiter erläutert, welche schematisch in den Zeichnungen dargestellt sind. In den Zeichnungen zeigen:
- Fig. 1: eine perspektivische Ansicht einer erfindungsgemäßen Vorrichtung bei einem Wechselvorgang;
- Fig. 2: eine vergrößerte Detailansicht zu einem Verbindungsabschnitt der Vorrichtung von Figur 1 ;
- Fig. 3: eine perspektivische und teilweise geschnittene Ansicht der Vorrichtung von Figur 1 in einem Betriebszustand;
- Fig. 4: eine vergrößerte Detailansicht zu Anschlusselementen der Vorrichtung von Figur 3;
- Fig. 5: eine vergrößerte Ansicht eines mechanischen Verbindungselementes der Vorrichtung von Figur 3;
- Fig. 6: eine vergrößerte Detaildarstellung zu einer Rollenführung der Vorrichtung von Figur 3;
- Fig. 7: eine Vorderansicht eines Wechselmoduls für eine erfindungsgemäße Vorrichtung; und
- Fig. 8: eine geschnittene Seitenansicht des Wechselmoduls von Figur 7.

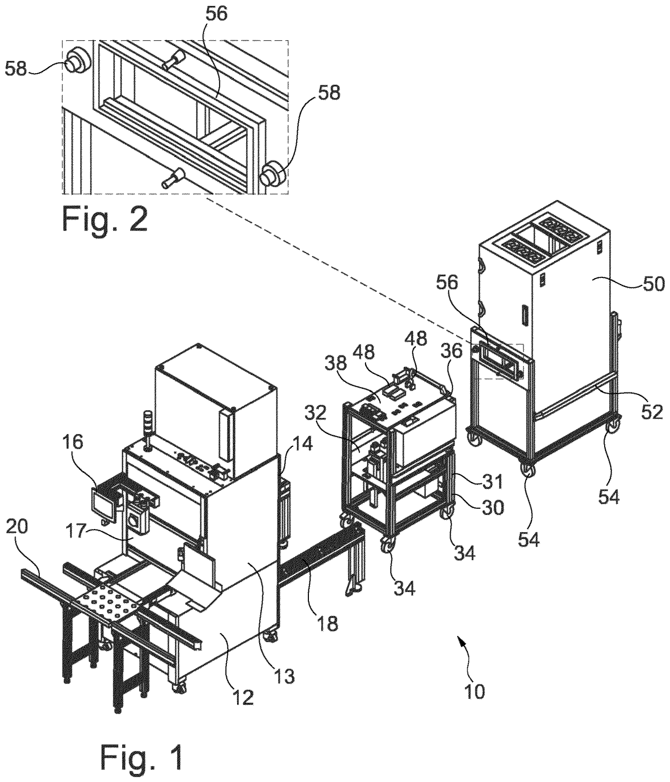

Eine erfindungsgemäße Vorrichtung 10 im Zustand eines Wechselvorganges ist im Zusammenhang mit den Figuren 1 und 2 dargestellt. Die Vorrichtung 10 umfasst einen stationären Grundrahmen 12 mit einem Gehäuse 13, welches einen inneren Aufnahmeraum 14 für ein einzuschiebendes Wechselmodul 30 aufweist.

An einer Vorderseite des Grundrahmens 12 ist eine Fördereinrichtung 20 zum Zuführen einer zu bearbeiteten Leistungselektronikeinheit angeordnet. Im vorliegenden Ausführungsfall ist die Fördereinrichtung 20 als Linearförderer zum Fördern eines plattenförmigen Werkstückträgers mit einer darauf angeordneten Leistungselektronikeinheit ausgebildet. Über eine Querfördereinrichtung kann die zu bearbeitende Leistungselektronikeinheit mit dem Werkstückträger über eine verschließbare Öffnung 17 in den Aufnahmeraum 14 in das Gehäuse 13 eingeführt werden.

Bei der erfindungsgemäßen Vorrichtung 10 ist ein leicht auswechselbares Wechselmodul 30 vorgesehen, welches in der dargestellten Ausführung als ein Trolley mit Grundgestell 31 mit Rollen 34 ausgeführt ist. An einer Oberseite 38 des kastenartigen Wechselmoduls 30 ist eine Vielzahl von oberen Anschlusselementen 48 zum Anschließen des Wechselmoduls 30 an dem Grundrahmen 12 ausgebildet. Der nähere Aufbau des Wechselmoduls 30 wird nachfolgend noch näher beschrieben werden.

Über eine Führungseinrichtung 18, welche mit Führungsschienen ausgebildet sein kann, kann das verschiebbare Wechselmodul 30, welches seitliche Führungsleisten aufweisen kann, von einer Rückseite des Grundrahmens 12 in den Aufnahmeraum 14 in dem Gehäuse 13 führt eingeschoben werden. Über obere Anschlusselemente 48 an der Oberseite 38 des Wechselmoduls 30 kann dieses mit den elektrischen und elektronischen Funktionskomponenten des Grundrahmens 12, welcher auch als eine stationäre Grundmaschine bezeichnet werden kann, verbunden werden.

Nach dem Einschieben des Wechselmoduls 30 in den Grundrahmen 12 kann zum abschließenden Bilden der Vorrichtung 10 die Prüf- und Einstelleinrichtung 50 zugeführt werden. Im vorliegenden Ausführungsbeispiel ist die Prüf-/Einstelleinrichtung 50 ebenfalls auf einem Gestell 51 mit Rollen 54 verschiebbar gelagert, so dass diese als ein Modul oder Trolley wie das Wechselmodul 30 an dem Grundrahmen 12 herangeschoben werden kann. Zum positionsgenauen Einschieben können an den Seiten der Prüf-/Einstelleinrichtung 50 Führungsleisten 52 angeordnet sein, welche mit der Führungseinrichtung 18 am Grundrahmen 12 zusammenwirken.

An einer Vorderseite der Prüf-/Einstelleinrichtung 50 ist ein schematisch dargestellter, einheitlicher erster Verbindungsabschnitt 56 angeordnet, welcher beim Einschieben in die Vorrichtung 10 mit einem korrespondierend hierzu ausgebildeten zweiten Verbindungsabschnitt 36 an einer Rückseite des Wechselmoduls 30 in Verbindung kommt, um so in besonders effizienter Weise und mit relativ kurzen Kabellängen eine Verbindung zu dem Wechselmodul 30 herzustellen.

An dem ersten Verbindungsabschnitt 56 können auch mechanische Befestigungselemente 58 angeordnet sein, wie aus Figur 2 ersichtlich ist. Diese Befestigungselemente 58 können mit korrespondierenden Befestigungselementen an dem zweiten Verbindungsabschnitt zur mechanischen Befestigung in Eingriff gebracht werden.

Nach dem Zusammenschieben ist die Vorrichtung 10 in einem grundsätzlich funktionsfähigen Zustand. Die Vorrichtung 10 kann beispielsweise von der Vorderseite über eine Bedieneinheit 16 mit einem Monitor bedient werden, welche etwa als ein Touchscreen ausgebildet sein kann.

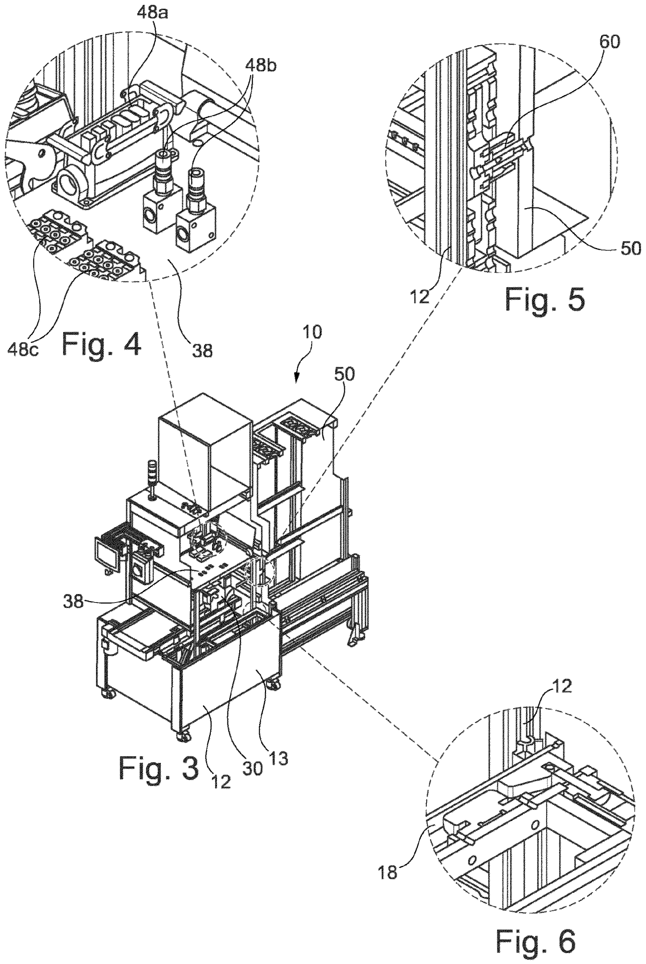

In Figur 3 ist die erfindungsgemäße Vorrichtung 10 in einem betriebsbereiten Zustand dargestellt, bei welchem sowohl das Wechselmodul 30 als auch die Prüf-/Einstelleinrichtung 50 an dem Grundrahmen 12 herangefahren und mit diesem verbunden sind. Das Wechselmodul 30 ist dabei insgesamt in dem Gehäuse 13 des Grundrahmens 12 aufgenommen. An der Oberseite 38 des Wechselmoduls 30 sind obere Anschlusselemente 48 angeordnet, um das Wechselmodul zur Grundversorgung mit Energie und/oder Daten an dem Grundrahmen 12 mit dessen Funktionskomponenten zu verbinden.

Wie insbesondere aus Figur 4 entnommen werden kann, kann ein erstes Anschlusselement 48a für eine elektronische Datenverbindung, zweite Anschlusselemente 48b für eine Verbindung mit Pneumatikleitungen und drittee Anschlusselemente 48c zur elektrischen Stromversorgung vorgesehen sein.

In der Detailansicht nach Figur 5 ist eine mögliche setliche Befestigungseinrichtung 60 dargestellt, mit welcher die Prüf-/Einstelleinrichtung 50 lösbar an dem Grundrahmen 12 befestigt werden kann.

Gemäß Figur 6 ist eine mögliche Ausführung der linearen Führungseinrichtung 18 an dem Grundrahmen 12 dargestellt. Die lineare Führungseinrichtung 18 kann insbesondere mit Rollenelementen für ein möglichst reibungsarmes Führen ausgebildet sein.

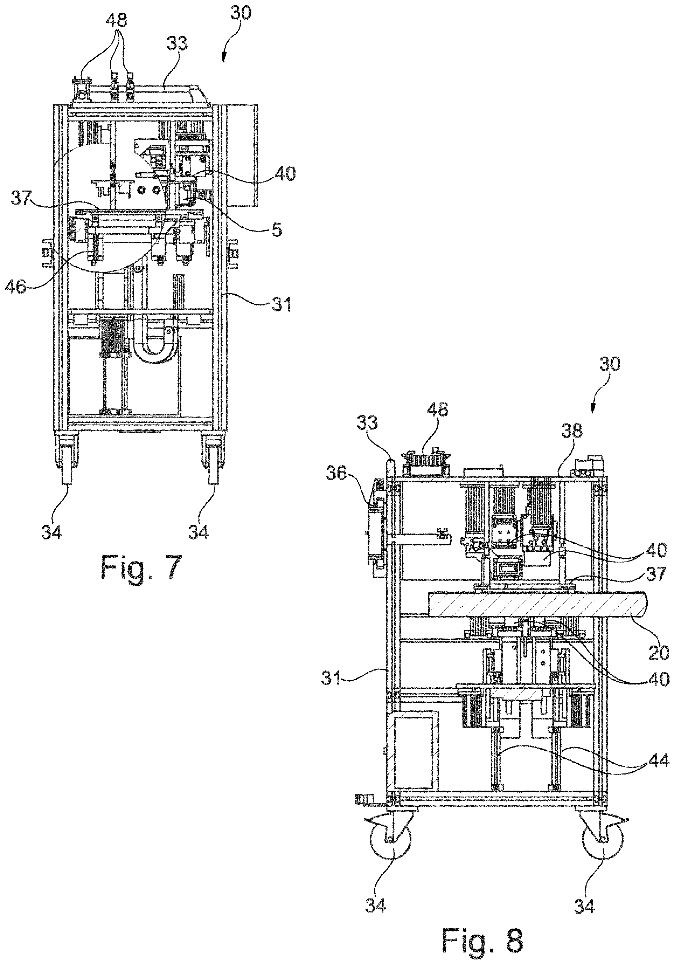

In den Figuren 7 und 8 ist eine erfindungsgemäße Ausgestaltung eines Wechselmoduls 30 gezeigt. Das dargestellte Wechselmodul 30 weist ein kastenartiges Grundgestell 31 auf, welches auf Rollen 34 verschiebbar gelagert ist. Zum Verschieben durch eine Bedienperson können an der Oberseite 38 ein oder mehrere Griffe 33 angebracht sein.

Innerhalb des Wechselmoduls 30 ist ein Aufnahmebereich 32 zum Aufnehmen einer schematisch angedeuteten Leistungselektronikeinheit 5 ausgebildet. Die Leistungselektronikeinheit 5 kann von einer Vorderseite des Wechselmoduls 30, in welche eine Bahn der Fördereinrichtung 20 des Grundrahmens 12 hineinreicht, mittels eines Werkstückträgers 37 in die Arbeitsposition durch eine Öffnung des Wechselmoduls 30 eingeführt werden. In dieser Arbeitsposition können Anschlusselemente 40 an dem Wechselmodul 30von oben und unten mittels schematisch dargestellte Stelleinrichtungen 44, welche insbesondere Pneumatikzylinder sein können, und Hub- oder Stellelementen mit den entsprechenden Anschlüssen an der Leistungselektronikeinheit 5 verbunden werden. Durch eine aktive Zentriereinrichtung 46 kann die Leistungselektronikeinheit 5 angehoben und in der Arbeitposition zentriert werden. In dem angeschlossenen Zustand können dann Prüf- und/oder Einstellschritte durch die angeschlossene Prüf-/Einstelleinrichtung 50 durchgeführt werden.

Zum Anschließen der Prüf-/Einstelleinrichtung 50 sind an einer Rückseite des Wechselmoduls 30, ein zweiter Verbindungsabschnitt 36 zum Verbinden der entsprechenden Prüf-, Mess- und/oder Kalibrierkomponenten der Prüf-/Einstelleinrichtung 50 angeordnet, wie schematisch aus Figur 8 hervorgeht.

Bei einer Änderung der zu bearbeitenden Leistungselektronikeinheit 5 kann die erfindungsgemäße Vorrichtung 10 in einfacher Weise umgerüstet werden. Hierzu ist zunächst die Prüf-/Einstelleinrichtung 50 von dem Grundrahmen 12 zu lösen und von diesem zu entfernen. Anschließend kann das Wechselmodul 30 aus dem Grundrahmen 12 herausgefahren und durch ein neues Wechselmodul 30 ersetzt werden, welches an den neuen Typ der zu bearbeitenden Leistungselektronikeinheit 5 angepasst ist.

Anschließend kann die Prüf-/Einstelleinrichtung 50 wieder an dem Grundrahmen 12 gefahren und die Vorrichtung 10 final montiert werden. Auf diese Weise kann eine schnelle Umrüstung erfolgen, so dass die insgesamt relativ kostenintensive Vorrichtung 10 zum Prüfen und/oder Einstellen einer Leistungselektronikeinheit 5 effizient an unterschiedliche Typen von Leistungselektronikeinheiten 5 angepasst werden kann. Bei der dargestellten Vorrichtung 10 ist die Prüf-/Einstelleinrichtung 50 selbst verschiebbar und wechselbar. Die Prüf-/Einstelleinrichtung 50 kann aber auch stationär an dem Grundrahmen 12 angeordnet sein.

## Patentansprüche

1. Vorrichtung zum Prüfen und/oder Einstellen einer Leistungselektronikeinheit (5), insbesondere für Kraftfahrzeuge, mit
- einer Aufnahme zum Aufnehmen und Halten der zu bearbeitenden Leistungselektronikeinheit (5),
- einer Prüf-/Einstelleinrichtung (50), welche mit mindestens einem elektronischen Programm zum Durchführen von Prüf-/Einstellschritten an der Leistungselektronikeinheit (5) ausgebildet ist, und
- einer Vielzahl von Anschlusselementen (40), welche zum Verbinden der Prüfeinrichtung mit der in der Aufnahme angeordneten Leistungselektronikeinheit (5) ausgebildet sind, wobei in dem Verbindungszustand ein Prüfen und/oder Einstellen von Funktionen der Leistungselektronikeinheit (5) durch die Prüf-/Einstelleinrichtung (50) durchführbar ist,
**dadurch gekennzeichnet,**
- **dass** die Aufnahme als ein Wechselmodul (30) ausgebildet ist, welches leicht lösbar und wechselbar an einem Grundrahmen (12) der Vorrichtung (10) angeordnet ist,
- **dass** an der Prüf-/Einstelleinrichtung (50) mindestens ein einheitlicher erster Verbindungsabschnitt (56) zum Herstellen von elektrischen und/oder elektronischen Verbindungen ausgebildet ist,
- **dass** an dem Wechselmodul (30) mindestens ein zum ersten Verbindungsabschnitt (56) passender zweiter Verbindungsabschnitt (36) zum Herstellen der elektrischen und/oder elektronischen Verbindungen (50) zwischen der Prüf-/Einstelleinrichtung (50) und dem Wechselmodul (30) ausgebildet ist, und
- **dass** die Vielzahl von Anschlusselementen (40) an dem Wechselmodul angeordnet und passend zum Anschließen einer vorgegebenen Leistungselektronikeinheit (5) ausgebildet ist.

2. Vorrichtung nach Anspruch 1,
**dadurch gekennzeichnet,**
**dass** das Wechselmodul (30) verschiebbar gelagert ist.

3. Vorrichtung nach Anspruch 1 oder 2,
**dadurch gekennzeichnet,**
**dass** an dem Grundrahmen (12) ein Einsetzbereich für das Wechselmodul (30) ausgebildet ist und
**dass** eine Führungseinrichtung (18) und/oder Anschlag (19) zum positionsgenauen Einschieben des Wechselmoduls (30) in den Grundrahmen (12) angeordnet sind.

4. Vorrichtung nach einem der Ansprüche 1 bis 3,
**dadurch gekennzeichnet,**
**dass** der zweite Verbindungsabschnitt (36) an einer Rückseite des Wechselmoduls (30) angeordnet ist und
**dass** ein Aufnahmebereich (32) für die Leistungselektronikeinheit (5) an dem Wechselmoduls (30) ausgebildet ist.

5. Vorrichtung nach einem der Ansprüche 1 bis 4,
**dadurch gekennzeichnet,**
**dass** an dem Grundrahmen (12) eine Fördereinrichtung (20) zum Zu- und/oder Abführen der Leistungselektronikeinheit (5) in eine bzw. aus einer Prüf-/Einstellposition angeordnet ist.

6. Vorrichtung nach einem der Ansprüche 1 bis 5,
**dadurch gekennzeichnet,**
**dass** ein oder mehrere Anschlusselemente (40) zwischen einer Rückzugsposition und einer Anschlussposition verstellbar gelagert und mittels mindestens einer Stelleinrichtung (44) zum automatischen Anschließen und/oder Lösen der Anschlusselemente (40) an bzw. von der Leistungselektronikeinheit (5) verstellbar sind.

7. Vorrichtung nach einem der Ansprüche 1 bis 6,
**dadurch gekennzeichnet,**
**dass** die Anschlusselemente (40) zum Bilden einer elektrischen, elektronischen und/oder fluidischen Steckverbindung ausgebildet sind.

8. Vorrichtung nach einem der Ansprüche 1 bis 7,
**dadurch gekennzeichnet,**
**dass** die Prüf-/Einstelleinrichtung (50) als ein Modul ausgebildet ist, welches verstellbar, insbesondere verschiebbar, gegenüber dem Grundrahmen (12) gelagert ist.

9. Vorrichtung nach einem der Ansprüche 1 bis 8,
**dadurch gekennzeichnet,**
**dass** das Wechselmodul (30) und/oder die Prüf-/Einstelleinrichtung (50) auf Rollen (34, 54) verschiebbar gelagert und insbesondere als ein Trolley ausgebildet sind.

10. Verfahren zum Prüfen und/oder Einstellen einer Leistungselektronikeinheit (5), insbesondere für Kraftfahrzeuge, insbesondere mit einer Vorrichtung (10) nach einem der Ansprüche 1 bis 9, bei dem
- eine zu bearbeitende Leistungselektronikeinheit (5) in einer Aufnahme einer Vorrichtung (10) zum Prüfen und/oder Einstellen aufgenommen und gehalten wird,
- die zu bearbeitende Leistungselektronikeinheit (5) über eine Vielzahl von Anschlusselementen (40) mit einer Prüf-/Einstelleinrichtung (50) verbunden wird und
- mittels der Prüf-/Einstelleinrichtung (50) mit mindestens einem elektronischen Programm Prüf-/Einstellschritte an der Leistungselektronikeinheit (5) zum Prüfen und/oder Einstellen von Funktionen der Leistungselektronikeinheit (5) durchgeführt werden,
**dadurch gekennzeichnet,**
- **dass** die Aufnahme als ein Wechselmodul (30) ausgebildet ist, welches leicht lösbar und wechselbar an einem Grundrahmen (12) der Vorrichtung (10) angeordnet wird,
- **dass** an der Prüf-/Einstelleinrichtung (50) ein einheitlicher erster Verbindungsabschnitt (56) zum Herstellen von elektrischen und/oder elektronischen Verbindungen und an dem Wechselmodul (30) ein zum ersten Verbindungsabschnitt (56) passender zweiter Verbindungsabschnitt (36) zum Herstellen der elektrischen und/oder elektronischen Verbindungen zwischen der Prüf-/Einstelleinrichtung (50) und dem Wechselmodul (30) ausgebildet sind, wobei die beiden Verbindungsabschnitte (36, 56) miteinander verbunden werden, und
- **dass** die Vielzahl von Anschlusselementen (40) an dem Wechselmodul(30) angeordnet sind, wobei die Anschlusselemente (40) an dem Wechselmodul (30) an der zu prüfenden Leistungselektronikeinheit (5) angeschlossen werden.

11. Verfahren nach Anspruch 10,
**dadurch gekennzeichnet,**
**dass** das Zuführen der Leistungselektronikeinheit (5), das Anschließen der Anschlusselemente (40), das Prüfen und/oder das Abführen der Leistungselektronikeinheit (5) teilweise oder vollständig automatisch gesteuert durchgeführt werden.

## Geänderte Patentansprüche

### Geänderte Patentansprüche gemäss Regel 137(2) EPÜ.

1. Vorrichtung (10) zum Prüfen und/oder Einstellen einer Leistungselektronikeinheit (5), insbesondere für Kraftfahrzeuge, mit
- einer Aufnahme zum Aufnehmen und Halten der zu bearbeitenden Leistungselektronikeinheit (5),
- einer Prüf-/Einstelleinrichtung (50), welche mit mindestens einem elektronischen Programm zum Durchführen von Prüf-/Einstellschritten an der Leistungselektronikeinheit (5) ausgebildet ist, und
- einer Vielzahl von Anschlusselementen (40), welche zum Verbinden der Prüf-/Einstelleinrichtung (50) mit der in der Aufnahme angeordneten Leistungselektronikeinheit (5) ausgebildet sind, wobei in dem Verbindungszustand ein Prüfen und/oder Einstellen von Funktionen der Leistungselektronikeinheit (5) durch die Prüf-/Einstelleinrichtung (50) durchführbar ist, wobei
- die Aufnahme als ein Wechselmodul (30) ausgebildet ist, welches leicht lösbar und wechselbar an einem Grundrahmen (12) der Vorrichtung (10) angeordnet ist,
- an der Prüf-/Einstelleinrichtung (50) mindestens ein einheitlicher erster Verbindungsabschnitt (56) zum Herstellen von elektrischen und/oder elektronischen Verbindungen ausgebildet ist,
- an dem Wechselmodul (30) mindestens ein zum ersten Verbindungsabschnitt (56) passender zweiter Verbindungsabschnitt (36) zum Herstellen der elektrischen und/oder elektronischen Verbindungen zwischen der Prüf-/Einstelleinrichtung (50) und dem Wechselmodul (30) ausgebildet ist, und
- die Vielzahl von Anschlusselementen (40) an dem Wechselmodul angeordnet und passend zum Anschließen der vorgegebenen Leistungselektronikeinheit (5) ausgebildet ist,
**dadurch gekennzeichnet,**
- **dass** die Prüf-/Einstelleinrichtung (50) als ein Modul ausgebildet ist, welches verschiebbar gegenüber dem Grundrahmen (12) gelagert ist.

2. Vorrichtung (10) nach Anspruch 1,
**dadurch gekennzeichnet,**
**dass** das Wechselmodul (30) verschiebbar gelagert ist.

3. Vorrichtung (10) nach Anspruch 1 oder 2,
**dadurch gekennzeichnet,**
**dass** an dem Grundrahmen (12) ein Einsetzbereich für das Wechselmodul (30) ausgebildet ist und
**dass** eine Führungseinrichtung (18) und/oder Anschlag zum positionsgenauen Einschieben des Wechselmoduls (30) in den Grundrahmen (12) angeordnet sind.

4. Vorrichtung (10) nach einem der Ansprüche 1 bis 3,
**dadurch gekennzeichnet,**
**dass** der zweite Verbindungsabschnitt (36) an einer Rückseite des Wechselmoduls (30) angeordnet ist, und
**dass** ein Aufnahmebereich (32) für die Leistungselektronikeinheit (5) an dem Wechselmodul (30) ausgebildet ist.

5. Vorrichtung (10) nach einem der Ansprüche 1 bis 4,
**dadurch gekennzeichnet,**
**dass** an dem Grundrahmen (12) eine Fördereinrichtung (20) zum Zu- und/oder Abführen der Leistungselektronikeinheit (5) in eine bzw. aus einer Prüf-/Einstellposition angeordnet ist.

6. Vorrichtung (10) nach einem der Ansprüche 1 bis 5,
**dadurch gekennzeichnet,**
**dass** ein oder mehrere der Anschlusselemente (40) zwischen einer Rückzugsposition und einer Anschlussposition verstellbar gelagert und mittels mindestens einer Stelleinrichtung (44) zum automatischen Anschließen und/oder Lösen der Anschlusselemente (40) an bzw. von der Leistungselektronikeinheit (5) verstellbar sind.

7. Vorrichtung (10) nach einem der Ansprüche 1 bis 6,
**dadurch gekennzeichnet,**
**dass** die Anschlusselemente (40) zum Bilden einer elektrischen, elektronischen und/oder fluidischen Steckverbindung ausgebildet sind.

8. Vorrichtung (10) nach einem der Ansprüche 1 bis 7,
**dadurch gekennzeichnet,**
**dass** das Wechselmodul (30) von einer Rückseite des Grundrahmens (12) in einen Aufnahmeraum (14) in einem Gehäuse (13) des Grundrahmens (12) geführt einschiebbar ist.

9. Vorrichtung (10) nach einem der Ansprüche 1 bis 8,
**dadurch gekennzeichnet,**
**dass** das Wechselmodul (30) und/oder die Prüf-/Einstelleinrichtung (50) auf Rollen (34, 54) verschiebbar gelagert ist/sind, so dass dieses/diese als ein/das Modul, vorzugsweise als ein Trolley ausgebildet, an den Grundrahmen (12) herangeschoben werden kann/können.

10. Verfahren zum Prüfen und/oder Einstellen einer Leistungselektronikeinheit (5), insbesondere für Kraftfahrzeuge, insbesondere mit einer Vorrichtung (10) nach einem der Ansprüche 1 bis 9, bei dem
- eine zu bearbeitende Leistungselektronikeinheit (5) in einer Aufnahme einer Vorrichtung (10) zum Prüfen und/oder Einstellen aufgenommen und gehalten wird,
- die zu bearbeitende Leistungselektronikeinheit (5) über eine Vielzahl von Anschlusselementen (40) mit einer Prüf-/Einstelleinrichtung (50) verbunden wird, und
- mittels der Prüf-/Einstelleinrichtung (50) mit mindestens einem elektronischen Programm Prüf-/Einstellschritte an der Leistungselektronikeinheit (5) zum Prüfen und/oder Einstellen von Funktionen der Leistungselektronikeinheit (5) durchgeführt werden,
wobei
- die Aufnahme als ein Wechselmodul (30) ausgebildet ist, welches leicht lösbar und wechselbar an einem Grundrahmen (12) der Vorrichtung (10) angeordnet wird,
- an der Prüf-/Einstelleinrichtung (50) ein einheitlicher erster Verbindungsabschnitt (56) zum Herstellen von elektrischen und/oder elektronischen Verbindungen und an dem Wechselmodul (30) ein zum ersten Verbindungsabschnitt (56) passender zweiter Verbindungsabschnitt (36) zum Herstellen der elektrischen und/oder elektronischen Verbindungen zwischen der Prüf-/Einstelleinrichtung (50) und dem Wechselmodul (30) ausgebildet sind, wobei die beiden Verbindungsabschnitte (36, 56) miteinander verbunden werden, und
- die Vielzahl von Anschlusselementen (40) an dem Wechselmodul (30) angeordnet sind, wobei die Anschlusselemente (40) an dem Wechselmodul (30) an der zu prüfenden Leistungselektronikeinheit (5) angeschlossen werden,
**dadurch gekennzeichnet,**
- **dass** die Prüf-/Einstelleinrichtung (50) als ein Modul an den Grundrahmen (12) herangeschoben wird, um die Verbindung zu dem Wechselmodul (30) herzustellen.

11. Verfahren nach Anspruch 10,
**dadurch gekennzeichnet,**
**dass** ein Zuführen der Leistungselektronikeinheit (5), das Anschließen der Anschlusselemente (40), das Prüfen und/oder ein Abführen der Leistungselektronikeinheit (5) teilweise oder vollständig automatisch gesteuert durchgeführt werden.
